# EUROPEAN PATENT SPECIFICATION

(11) **EP 0 415 659 B1**
(45) Date of publication and mention of the grant of the patent: **23.04.1997**
(21) Application number: 90309293.0
(22) Date of filing: 24.08.1990
(51) Int. Cl.: H01L 21/48, H01L 23/498

(54) **Process for making a two-layer film carrier**
Prozess zur Herstellung eines Zweischichtenfilmträgers
Procédé pour fabriquer un support de film à deux couches

(30) Priority: 28.08.1989 JP 218723/89
(43) Date of publication of application: 06.03.1991
(73) Proprietor: SUMITOMO METAL MINING COMPANY LIMITED, Tokyo 105 (JP)
(72) Inventor: Chonan, Takeshi, Ichikawa City, Chiba Pref. (JP); Kudo, Yuko, Ichikawa City, Chiba Pref. (JP); Hirota, Yoshihiro, Ichikawa City, Chiba Pref. (JP)
(74) Representative: Sarup, David Alexander

(56) References cited:
- GB-A- 2 169 553
- GB-A- 2 178 231
- US-A- 3 838 984

## Description

### 1. Field of the Invention:

This invention relates to a process for making two-layer film carrier for TAB.

### 2. Description of the Prior Art:

Although wire bonding has hitherto been used for interconnecting the component parts of an IC package, TAB (tape automated bonding) is now considered as a better method for interconnections for making a multi-pinned type of IC. There are known three types of film carriers for TAB.
(1) Firstly, there is known a one-layer film carrier formed from a single metal, such as copper or aluminium. This type of film carrier can be made at a low cost, but as a base material having a given thickness is worked on directly, it is difficult to make a finely and accurately worked product. This type of film carrier does not lend itself to use for interconnecting the parts of a multi-pinned IC and therefore has only a limited scope of application.
(2) Secondly, there is known a three-layer film carrier composed of a copper foil, a polyimide film and an adhesive by which the copper foil is bonded to the polyimide film. The use of the adhesive, however, spoils the benefits of use of the polyimide having high heat resistance and insulating property. Moreover, the manufacture of this type of film carrier has an economical disadvantage, as it requires an expensive punching tool for making sprocket and device holes.

GB2178231A discloses such a three-layer film carrier produced by the so called "subtractive method" which comprises fixing a copper foil to a polyimide tape by means of an adhesive, coating the major faces of the thus formed tape with a photoresist and removing the photoresist by developing and etching the exposed copper surface.

GB2169553A discloses a three-layer film carrier in which a pre-punched polyimide film is laminated with a polyimide adhesive to a layer of conductive material.
(3) Thirdly, there is known a two-layer film carrier comprising a substrate which consists of a polyimide film and a metal layer formed on a surface of the polyimide film. This type of film carrier has been proposed as an improvement over the two types of film carriers as hereinabove described, and is claimed to enable the interconnections for a multi-pinned IC.

Although no detail is known as to any specific process that is used for making a two-layer film carrier, it is assumed that a process including the following steps is generally employed:
(a)Forming a photoresist coating having an appropriate thickness on a copper surface;
(b) Exposing the photoresist to light through a mask defining a desired pattern;
(c)Developing the exposed photoresist to expose the copper surface in the desired pattern;
(d)Forming a copper layer by additive plating;
(e)Dissolving and removing the remaining photoresist and removing the copper layer by flush etching;
(f) Applying a photoresist onto both sides;
(g) Exposing the photoresist on a polyimide film to light in a desired pattern;
(h) Developing the exposed photoresist to expose the selected portions of the polyimide film;
(i) Etching the exposed portions of the polyimide film;
(j) Removing the remaining photoresist from the polyimide film; and
(k) Forming a plated layer of gold or tin, if required.

This process is, however, considered to have a number of problems as will hereinafter be pointed out:
(1) As the polyimide film remains exposed to the plating solution, etc. for a long time throughout the steps (d) and (e), its property of being wetted with the photoresist becomes so low that the photoresist applied to it during the step (f) is likely to peel off at any time thereafter;
(2) As the step (g) of exposure to light comes after the formation of leads, the unevenness of the surface on which the leads have been formed causes the scattering of light, resulting in a lower degree of resolution; and
(3) As the photoresists on the copper and the polyimide film are separately exposed to light, the accurate positioning of the patterns on both sides is difficult to achieve, and the operation is inefficient and is difficult to perform continuously.

These problems allow the process to produce only a two-layer film carrier which is expensive, and yet which cannot satisfactorily be used for interconnecting the parts of an IC package having a multi-pinned layer.

### SUMMARY OF THE INVENTION

Under these circumstances, it is an object of this invention to provide a process which can make an inexpensive two-layer film carrier which can satisfactorily be used for interconnecting the parts of an IC package having a multi-pinned layer.

This object is attained by a process of making a two-layer film carrier comprising a first metal layer (2) formed on a polyimide film (1) by additive plating, the process comprising:
(1) forming a photoresist layer (3) on the first metal layer (2), and a photoresist layer (3) on the polyimide film (1) ;
(2) exposing both of said photoresist layers (3) simultaneously to light through a mask applied to each photoresist layer (3) to define a desired pattern;
(3) developing the exposed photoresist layer (3) on the first metal layer (2) to expose selected portions of the first metal layer (2);
(4) additive plating the exposed portions of the first metal layer (2) with a copper layer to form leads (4);
(5) developing the exposed photoresist layer (3) on the polyimide film (1) and postbaking it to expose selected portions of the polyimide film;
(6) removing the remaining photoresist layer (3) from the first metal layer (2) and etching that layer;
(7) etching the exposed portions of the polyimide film (1) to form holes (5, 6, 7) therethrough; and
(8) removing the remaining photoresist layer (3) from the polyimide film (1).

The photoresist layer formed on one surface of the substrate, or the first metal, preferably copper, layer is preferably one having a thickness of at least 30 micrometers and formed by covering it with an alkali-developable negative photoresist solution having a viscosity of at least 4·10⁻² Pa·s (40 cp) and a solid content of at least 20% and the photoresist layer on the other surface of the substrate, or the polyimide film preferably has a thickness of 2 to 10 micrometers (step (1)). The postbaking of the developed photoresist on the first metal layer is, preferably, carried out by heating at a temperature of lower than 130°C for a period of 10 to 90 minutes.

It is preferable that the first metal layer on the polyimide film by additive plating be further electroplated with copper. It is preferable that the surfaces of the leads be finished by plating.

According to the process of this invention, the photoresist layers on both surfaces of the substrate are simultaneously exposed to light, and after a desired pattern has been formed, the first metal layer on one surface of the substrate is first etched. Therefore, it enables the manufacturing of a very accurately processed two-layer film carrier which can be used effectively during the manufacture of a multi-pinned IC package. Moreover, the process can be carried out continuously and thereby make a two-layer film carrier at a low cost.

Other features and advantages of this invention will become apparent from the following description and the accompanying drawings.

### BRIEF DESCRIPTION OF THE DRAWINGS

Figures 1-A to 1-H are a series of elevational and sectional views showing the various steps of a process embodying this invention; and
Figure 2 is a top plan view of a two-layer film carrier made by way of example in accordance with the process of this invention.

### DETAILED DESCRIPTION OF THE INVENTION

The process of this invention is used for making a two-layer film carrier from a substrate comprising a polyimide film and a copper layer formed thereon either by additive plating, or by additive plating and electroplating following it. The process is also applicable to a substrate comprising a polyimide film and a layer of another metal, such as nickel, chromium or silver, which has been formed thereon in a similar way.

It is necessary to control appropriately the characteristic impedances of an IC including the interconnections in order to increase the speed of signal transmission to and from it. In this connection, and also in view of the technical limitation to the interconnections, it is important to achieve an appropriate conductor thickness. This thickness is in the range of 30 to 50 micrometers. Therefore, it is advisable to form a photoresist layer having a thickness of at least 30 micrometers on the copper side of the substrate. Any material can be used if it can form a layer having such a thickness. It is, however, likely that a photoresist in the form of a solution may be preferred, as it is easy to handle or use. In such an event, it is desirable to use an alkali-developable negative photoresist solution having a viscosity of at least 4·10⁻² Pa·s (40 cp) and a solid content of at least 20%.

Any photoresist material can be used for covering the polyimide film to form device and sprocket holes if it has the property of resisting the substance used for etching the polyimide film. A material of the rubber series can, for example, be used. The photoresist layer formed on the polyimide film preferably has a thickness of 2 to 10 micrometers. Pinholes or other defects are likely to appear in any layer having a smaller thickness, while a layer having a larger thickness may allow only patterning with low accuracy.

A bar coater can, for example, be used for applying a photoresist solution to the copper layer, or polyimide film, though any other appropriate device or method can also be employed. The photoresist which has been applied to each side of the substrate is prebaked. The conditions for such prebaking are known in the art and do not, therefore, form a part of this invention.

The photoresist layers on both sides of the substrate are appropriately masked and are simultaneously exposed to light. The simultaneous exposure enables the achievement of a high level of positioning accuracy in patterning on either side and an improved operating efficiency, and contributes to permitting the process to be carried out continuously.

The exposed photoresist on the copper layer is subjected to development before that on the polyimide film is. After development, the photoresist is postbaked. Its postbaking is not essential, but is preferable to promote its drying and improve its adhesion to the substrate. The postbaking of the photoresist on the copper layer is preferably carried out by heating at a temperature of 100°C to 130°C for a period of 10 to 90 minutes, so that it may not exert any adverse effect on the photoresist on the polyimide film. The use of a higher temperature and a longer time would result in the failure of the photoresist on the polyimide film to be satisfactorily developed, while the use of a lower temperature and a shorter time would fail to produce any satisfactory result of postbaking in the photoresist on the copper layer.

After development and postbaking, leads are formed by the additive plating of the exposed portions of the copper layer with copper. The additive plating may be either semi-additive or full-additive.

The photoresist on the polyimide film which has been exposed to light is, then, subjected to development and postbaking. The remaining photoresist is removed from the copper layer and the underlying copper layer is etched. Then, the exposed portions of the polyimide film are etched and the remaining photoresist is removed from the polyimide film. The etching of the copper layer is done before that of the polyimide film, as it does not exert any adverse effect on the polyimide film. Finally, the surfaces of the leads may or may not be finished by plating.

The conditions for the postbaking of the photoresist on the polyimide film, the removal of the photoresist from the copper layer, the etching of the copper layer or the polyimide film, etc. are not particularly specified herein, as they are all known in the art.

The invention will now be described more specifically with reference to a few examples thereof.

### EXAMPLE 1

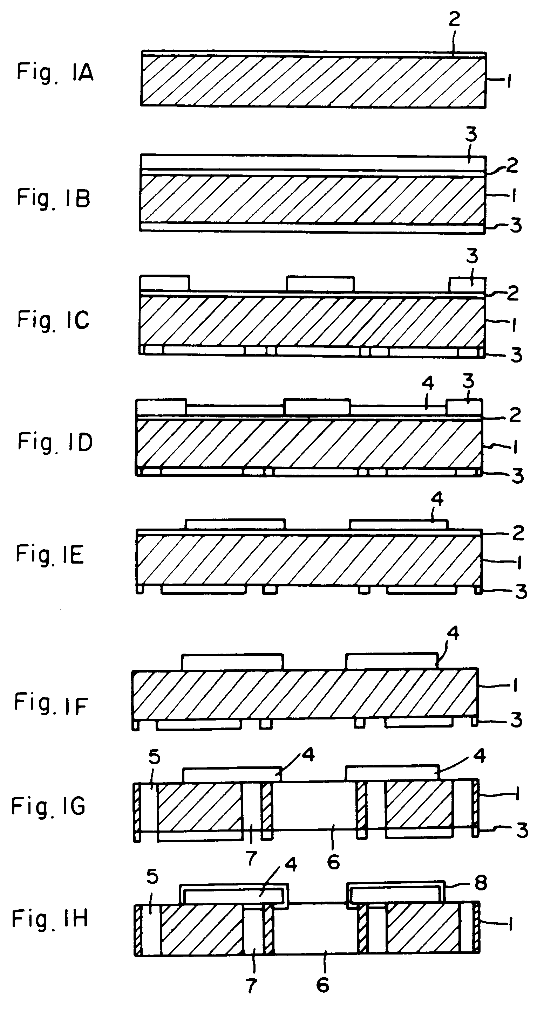

A two-layer film carrier was made by a process embodying this invention as shown in FIGURES 1-A to 1-H. The process was applied to a substrate comprising a polyimide film having a thickness of 50 micrometers (a product of Dupont-Toray Co., Ltd. sold under the name "Kapton") and a copper layer formed on one surface of the polyimide film by sputtering and having a thickness of one micrometer (FIGURE 1-A).

An alkali-developable negative photoresist solution having a viscosity of at least 4·10⁻² Pa·s (40 cp) and a solid content of at least 20% was applied by a bar coater onto the surface of the copper layer 2 and was prebaked at 70°C for 30 minutes to form a prebaked photoresist layer 3 having a thickness of about 45 micrometers (FIGURE 1-B). Similarly, a negative photoresist solution was applied by a bar coater onto the surface of the polyimide film 1 and was prebaked at 70°C for 30 minutes to form a prebaked photoresist layer 3 having a thickness of about five micrometers (FIGURE 1-B).

The photoresist layers 3 on both sides of the substrate were simultaneously exposed to light through a mask applied to each side in accordance with a selected pattern. The exposed portions of the photoresist 3 on the copper layer 2 were subjected to development, and postbaked at 110°C for 30 minutes, whereby selected portions of the copper layer 2 were exposed (FIGURE 1-C). The exposed portions of the copper layer 2 were electroplated with copper at a current density of 2 A/dm² for a period of 50 minutes, whereby leads having a thickness of about 35 micrometers were formed as shown at 4 (FIGURE 1-D).

Those portions of the photoresist 3 on the polyimide film 1 which had been exposed to light were subjected to development, and postbaked at 130°C for 30 minutes, and the substrate was dipped in a 4% NaOH solution having a temperature of 60°C and left to stand for one minute, whereby the remaining photoresist 3 was removed from the copper layer 2 (FIGURE 1-E). Then, it was dipped in a cuprous chloride solution having a temperature of 50°C and left to stand for 30 seconds, whereby the underlying copper layer 2 was dissolved away (Figure 1-F).

The substrate was, then, dipped in an etching solution prepared by mixing hydrazine hydrate and ethylenediamine in a ratio by volume of 8:2, and having a temperature of 50°C, and was left to stand for five minutes, whereby various holes 5 to 7 (sprocket, device and outer lead holes) were formed through the polyimide film 1 (Figure 1-G). Then, the remaining photoresist 3 was removed from the polyimide film 1 by using a solvent containing 20% by volume of each of chlorobenzene and tetrachloroethylene.

Finally, the lead surfaces were given a finish by three minutes of gold plating at a current density of 1 A/dm², whereby there was obtained a two-layer film carrier having a lead width of 70 micrometers and a space width of 60 micrometers (Figure 1-H).

### EXAMPLE 2

A two-layer film carrier was made by repeating the process of EXAMPLE 1, except that the substrate consisted of a polyimide film having a thickness of 50 micrometers ("Kapton" of Dupont-Toray Co., Ltd) and a copper layer consisting of a layer formed on the polyimide film by electroless plating and having a thickness of 0.25 micrometer and a layer formed on the electrolessly plated layer by electroplating and having a thickness of one micrometer, and that the copper layer was coated with the negative photoresist solution sold by Tokyo Ohka Kogyo Kabushiki Kaisha under the designation "PMER HC 600", and the polyimide film with the negative photoresist sold by Fuji Yakuhin Kogyo Kabushiki Kaisha under the designation "FSR".

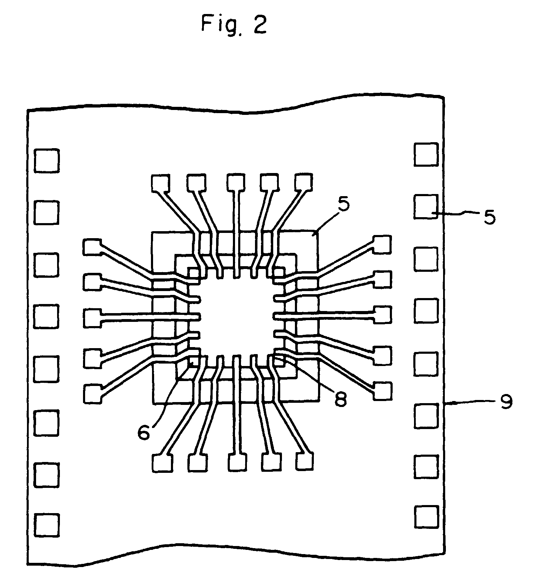

It was similar to the product of EXAMPLE 1 and its top plan was as shown in FIGURE 2, in which the two-layer film carrier is shown at 9, its sprocket holes at 5, its device hole at 6, and its inner leads at 8.

## Claims

1. A process of making a two-layer film carrier comprising a first metal layer (2) formed on a polyimide film (1) by additive plating, the process comprising:
(1) forming a photoresist layer (3) on the first metal layer (2), and a photoresist layer (3) on the polyimide film (1);
(2) exposing both of said photoresist layers (3) simultaneously to light through a mask applied to each photoresist layer (3) to define a desired pattern;
(3) developing the exposed photoresist layer (3) on the first metal layer (2) to expose selected portions of the first metal layer (2);
(4) additive plating the exposed portions of the first metal layer (2) with a copper layer to form leads (4);
(5) developing the exposed photoresist layer (3) on the polyimide film (1) and postbaking it to expose selected portions of the polyimide film;
(6) removing the remaining photoresist layer (3) from the first metal layer (2) and etching that layer;
(7) etching the exposed portions of the polyimide film (1) to form holes (5, 6, 7) therethrough; and
(8) removing the remaining photoresist layer (3) from the polyimide film (1).

2. A process according to claim 1, wherein after additive plating of the first metal layer (2) this is further electroplated with a copper layer.

3. A process according to claim 1 or 2, wherein the photoresist layer (3) on the first metal layer (2) is formed by covering the first metal layer (2) with an alkali-developable negative photoresist solution having a viscosity of at least 4·10⁻²Pa·s (40 cP) and a solid content of at least 20% and prebaking it, while the photoresist layer (3) on the polyimide film (1) is formed by covering said film with a photoresist of the rubber series and prebaking it.

4. A process according to claim 3, wherein the photoresist layer (3) on the first metal layer (2) is at least 30 micrometers thick, and the photoresist layer (3) on the polyimide film is from two to 10 micrometers thick.

5. A process according to claim 1 or 2, wherein the developed photoresist layer (3) on the first metal layer (2) is subjected to postbaking at a temperature of lower than 130°C for a period of 10 to 90 minutes so as to expose selected portions of the first metal layer (2).

6. A process according to claim 1 or 2, further including the step of:
(9) giving said leads a surface finish by plating.

7. A process according to any preceding claim in which the first metal is copper, nickel, chromium or silver.

## Patentansprüche

1. Prozeß zur Herstellung eines Zweischichtenfilmträgers mit einer ersten Metallschicht (2), die auf einem Polyimidfilm (1) durch additives Plattieren ausgebildet ist, wobei der Prozeß aufweist:
(1) Bilden einer Photoresistschicht (3) auf der ersten Metallschicht (2) und einer Photoresistschicht (3) auf dem Polyimidfilm (1);
(2) gleichzeitiges Belichten beider genannter Photoresistschichten (3) mit Licht durch eine Maske hindurch, die an jeder Photoresistschicht (3) angelegt ist, um ein gewünschtes Muster zu definieren;
(3) Entwickeln der belichteten Photoresistschicht (3) an der ersten Metallschicht (2), um ausgewählte Teile der ersten Metallschicht (2) freizulegen;
(4) additives Plattieren der freigelegten Teile der ersten Metallschicht (2) mit einer Kupferschicht, um Leiter (4) zu bilden;
(5) Entwickeln der belichteten Photoresistschicht (3) an dem Polyimidfilm (1) und Nachhärten derselben, um ausgewählte Teile des Polyimidfilms freizulegen;
(6) Entfernen der verbleibenden Photoresistschicht (3) von der ersten Metallschicht (2) und Ätzen dieser Schicht;
(7) Ätzen der freiliegenden Teile des Polyimidfilms (1), um durchgehende Löcher (5, 6, 7) zu bilden, und
(8) Entfernen der verbleibenden Photoresistschicht (3) von dem Polyimidfilm (1).

2. Prozeß nach Anspruch 1, bei dem nach dem additiven Plattieren der ersten Metallschicht (2) diese ferner mit einer Kupferschicht elektroplattiert wird.

3. Prozeß nach Anspruch 1 oder 2, bei dem die Photoresistschicht (3) auf der ersten Metallschicht (2) gebildet wird, indem die erste Metallschicht (2) mit einer alkali-entwickelbaren, negativen Photoresistlösung mit einer Viskosität von zumindest 4 · 10⁻²Pa · s (40 cP) und einem Feststoffgehalt von zumindest 20% überzogen wird, die vorgehärtet wird, während die Photoresistschicht (3) auf dem Polyimidfilm (1) gebildet wird, indem der genannte Film mit einem Photoresist der Gummireihe überzogen und dieser vorgehärtet wird.

4. Prozeß nach Anspruch 3, bei dem die Photoresistschicht (3) auf der ersten Metallschicht (2) zumindest 30 Mikrometer dick und die Photoresistschicht (3) auf dem Polyimidfilm zwei bis 10 Mikrometer dick sind.

5. Prozeß nach Anspruch 1 oder 2, bei dem die entwickelte Photoresistschicht (3) auf der ersten Metallschicht (2) einer Nachhärtung bei einer Temperatur von weniger als 130°C über einen Zeitraum von 10 bis 90 Minuten unterzogen wird, um ausgewählte Teile der ersten Metallschicht (2) freizulegen.

6. Prozeß nach Anspruch 1 oder 2, außerdem den Schritt aufweisend:
(9) Bewirken eines Oberflächenfinish an den genannten Leitern durch Plattieren.

7. Prozeß nach irgendeinem vorausgehenden Anspruch, bei dem das erste Metall Kupfer, Nickel, Chrom oder Silber ist.

## Revendications

1. Procédé de fabrication d'un support de film à deux couches comprenant une première couche de métal (2) formée sur un film polyimide (1) par métallisation additionnelle, le procédé consistant à :
(1) former une couche de photorésist (3) sur la première couche de métal (2), et une couche de photorésist (3) sur le film polyimide (1) ;
(2) exposer simultanément chacune de ces couches de photorésist (3) à la lumière à travers un masque appliqué à chaque couche de photorésist (3) pour définir un motif désiré ;
(3) développer la couche de photorésist (3) exposée formée sur la première couche de métal (2) afin d'exposer des parties choisies de la première couche de métal (2);
(4) métalliser additionnellement les parties exposées de la première couche de métal (2) avec une couche de cuivre pour former des conducteurs (4) ;
(5) développer la couche de photorésist (3) exposée formée sur le film polyimide (1) et la soumettre à une post-cuisson afin d'exposer les parties choisies du film polyimide ;
(6) enlever la couche de photorésist (3) restant sur la première couche de métal (2) et graver cette couche ;
(7) graver les parties exposées du film polyimide (1) afin de former des trous (5,6,7) à travers celui-ci ; et
(8) enlever la couche de photorésist (3) restant sur le film polyimide (1).

2. Procédé selon la revendication 1, dans lequel après métallisation additionnelle de la première couche de métal (2), celle-ci est ensuite métallisée par galvanisation avec une couche de cuivre.

3. Procédé selon l'une quelconque des revendications 1 ou 2, dans lequel la couche de photorésist (3) sur la première couche de métal (2) est formée en recouvrant la première couche de métal (2) d'une solution de photorésist négatif développable dans une solution alcaline présentant une viscosité d'au moins 4.10⁻² Pa.s (40 cP) et un contenu solide d'au moins 20 % et en la soumettant à une pré-cuisson, tandis que la couche de photorésist (3) sur le film polyimide (1) est formée en recouvrant ce film avec un photorésist du groupe des caoutchoucs et en la soumettant à une pré-cuisson.

4. Procédé selon la revendication 3, dans lequel la couche de photorésist (3) sur la première couche métallique (2) présente une épaisseur d'au moins 30 micromètres, et la couche de photorésist (3) sur le film polyimide présente une épaisseur comprise entre deux et dix micromètres.

5. Procédé selon l'une quelconque des revendications 1 ou 2, dans lequel la couche de photorésist (3) développée formée sur la première couche de métal (2) est soumise à une post-cuisson à une température inférieure à 130°C pendant une durée comprise entre dix et quatre-vingt dix minutes, de façon à exposer les parties choisies de la première couche de métal (2).

6. Procédé selon l'une quelconque des revendications 1 ou 2, comprenant en outre l'étape qui consiste à :
(9) donner aux conducteurs un état de surface par électrodéposition.

7. Procédé selon l'une quelconque des revendications précédentes, dans lequel le premier métal est du cuivre, du nickel, du chrome ou de l'argent.
